## Europäisches Patentamt

## European Patent Office

## Office européen des brevets

(19)

(11) Veröffentlichungsnummer: **0 195 955**
**B1**

(12) # EUROPÄISCHE PATENTSCHRIFT

(45) Veröffentlichungstag der Patentschrift:
**16.08.89**

(21) Anmeldenummer: **86102732.4**

(22) Anmeldetag: **03.03.86**

(51) Int. Cl.⁴: **H05K 7/14, H01R 23/72**

(54) Rückwandverdrahtung für elektrische Baugruppen.

(30) Priorität: **28.03.85 DE 3511384**

(43) Veröffentlichungstag der Anmeldung:
**01.10.86 Patentblatt 86/40**

(45) Bekanntmachung des Hinweises auf die Patenterteilung
**16.08.89 Patentblatt 89/33**

(84) Benannte Vertragsstaaten:
**AT CH DE FR GB IT LI NL SE**

(56) Entgegenhaltungen:
**DE-A- 2 808 595**
**DE-A- 3 301 192**
**DE-U- 8 509 329**
**US-A- 4 464 007**

(73) Patentinhaber: **Siemens Aktiengesellschaft,**
**Wittelsbacherplatz 2, D-8000 München 2(DE)**

(72) Erfinder: **Thom, Günter, Ing. grad., Untertaxetweg 6,**
**D-8035 Gauting(DE)**
Erfinder: **Zell, Karl, Ing. grad.,**
**Moritz-von-Schwind-Weg 80, D-8134 Niederpöcking(DE)**

## Beschreibung

Die Erfindung betrifft eine Rückwandverdrahtung für elektrische Baugruppen, bestehend aus einer Rückwandleiterplatte mit eingesetzten Kontaktstiften und darauf aufsteckbaren als einseitig offene rechtwinklige Gehäuse ausgebildeten Zentrierleisten zur Aufnahme von Steckern oder Federleisten, die mit elektrischen Baugruppen fest verbunden sind, wobei die Zentrierleisten in Boden Durchtrittsöffnungen für die Kontaktstifte aufweisen; siehe z.B. DE-U 8 509 329.

Derartige Rückwandverdrahtungen sind in der Regel so ausgeführt, daß von vorne auf die Rückwandleiterplatte Baugruppen aufgeschoben werden und von hinten auf die entsprechenden Kontaktstifte der Rückwandleiterplatte Stecker eines Übergabesystems aufgeschoben werden. Die bekannten Rückwandverdrahtungen sind so aufgebaut, daß sie nur an den Stellen, an denen die vorderen Baugruppen aufgeschoben werden mit einem rasterförmig angeordneten Stiftfeld versehen sind. Diese bekannten Rückwandverdrahtungen weisen mehrere Nachteile auf. Zum einen kann die die Rückwandleiterplatte nicht vollständig ausgenutzt werden, und zum anderen fehlt eine Freizügigkeit bei der Beaufschlagung der Rückwandleiterplatte mit Federleisten bzw. mit Steckern. Je nach den beabsichtigten Anwendungsfällen müssen unterschiedliche Rückwandleiterplatten hergestellt und gelagert werden.

Aufgabe der vorliegenden Erfindung ist es eine Rückwandverdrahtung der eingangs genannten Art anzugeben, die ein freizügiges Aufstecken von Steckern und Federleisten von Baugruppen gewährleistet bei möglichst vollständiger Ausnutzung der Rückwandleiterplattenfläche.

Diese Aufgabe wird für eine Rückwandverdrahtung der obengenannten Art dadurch gelöst, daß die Rückwandleiterplatte ein vollständiges Stiftfeld aufweist, und daß die Zentrierleisten an ihren Längswänden seitliche Aussparungen zur Aufnahme von jeweils benachbarten Stiften aufweisen.

Dadurch, daß bei der erfindungsgemäßen Rückwandverdrahtung die Rückwandleiterplatte vollständig mit rasterförmig angeordneten Stiften belegt ist genügt eine einzige Ausführungsform für alle sich möglicherweise ergebenden Anforderungen. Durch die seitlichen Aussparungen an den Längswänden der Zentrierleistung ist darüber hinaus die Möglichkeit gegeben, Zentrierleisten direkt benachbart auf die Rückwandleiterplatte aufzuschieben, so daß sich eine möglichst vollständige Ausnutzung der Rückwandverdrahtung ergibt. Damit ergibt sich auch automatisch eine Fülle von Gestaltungsmöglichkeiten für das Aufschieben von Steckern bzw. Federleisten.

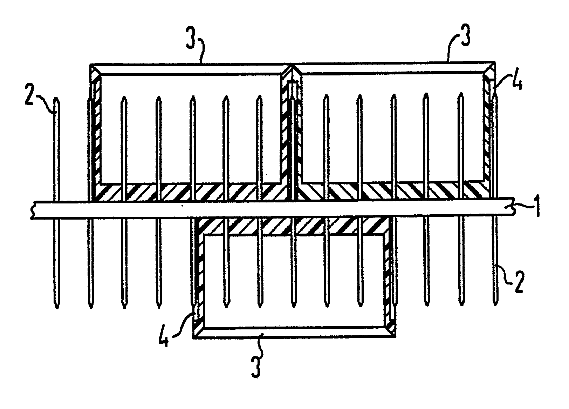

Im folgenden wird die Erfindung anhand eines in der Zeichnung dargestellten Ausführungsbeispieles näher erläutert.

Die dargestellte Figur zeigt schematisiert einen teilweisen Querschnitt durch eine gemäß der vorliegenden Erfindung aufgebaute Rückwandverdrahtung. Dargestellt ist die Rückwandleiterplatte 1, die vollständig mit rasterförmig angeordneten Kontaktstiften 2 belegt ist. Auf die Kontaktstifte 2 der Rückwandleiterplatte 1 können von beiden Seiten Zentrierleisten 3 aufgeschoben werden, die zur besseren Führung der Stecker bzw. Federleisten beim Aufstecken dienen. Dadurch, daß die Zentrierleisten 3 an ihren Längswänden seitliche Aussparungen 4 aufweisen ist es möglich auch bei einem vollständigen Stiftfeld die Zentrierleisten so auf die Kontaktstifte aufzuschieben, daß die Zentrierleisten eng benachbart sind. Auf diese Weise kann die gesamte Rückwandverdrahtung möglichst vollständig ausgenutzt werden.

Dadurch, daß die Rückwandleiterplatte voll mit Kontaktstiften 2 besetzt ist, besteht auch die Möglichkeit eines Übersteckens von sich gegenüberliegenden Baugruppen bzw. Steckern, wie es aus der Figur zu ersehen ist. So könnte z.B. ein Stecker bzw. eine Baugruppe zwei Baugruppen zugeordnet werden.

Bei der erfindungsgemäßen Rückwandverdrahtung können damit auch Stecker eines Übergabesystems unabhängig von den Einbauplätzen der elektrischen Baugruppen an den für die Abführung der Signale günstigsten Plätzen angeordnet werden. Auch ermöglicht die Rückwandverdrahtung einen gleichzeitigen Abgriff durch einen Stecker von Baugruppe und einer eventuell vorhandenen Rückwandverdrahtung.

## Patentansprüche

1. Rückwandverdrahtung für elektrische Baugruppen bestehend aus einer Rückwandleiterplatte mit eingesetzten Kontaktstiften und darauf aufsteckbaren als einseitig offene rechtwinklige Gehäuse ausgebildeten Zentrierleisten zur Aufnahme von Steckern oder Federleisten, die mit elektrischen Baugruppen fest verbunden sind, wobei die Zentrierleisten im Boden Durchtrittsöffnungen für die Kontaktstifte aufweisen, **dadurch gekennzeichnet, daß die Rückwandleiterplatte (1) ein vollständiges Stiftfeld aufweist, und daß die Zentrierleisten (3) an ihren Längswänden seitliche Aussparungen (4) zur Aufnahme von jeweils benachbarten Kontaktstiften (2) aufweisen.

## Claims

1. Back-panel wiring for electric equipment consisting of a back-panel printed-circuit board, having inserted contact pins and centring strips, which may be plugged thereon and are constructed as unilaterally open rectangular housing, and serve to accommodate plug connectors or socket connectors, which are firmly connected to electric equipment, the centring strips having openings in the case for the contact pins, characterized in that the back-panel printed-circuit board (1) has a complete array of pins, and in that at the longitudinal walls the centring strips (3) have lateral cutouts (4) for accommodating respective adjacent contact pins (2).

## Revendications

1. Câblage de panneau arrière pour sous-ensembles ou modules électriques, comprenant une plaque à circuits imprimés formant panneau arrière et dans laquelle sont fichées des broches de contact, sur lesquelles sont embrochables des réglettes de centrage réalisées comme des boîtiers rectangulaires ouverts d'un côté et destinés à recevoir des fiches ou des connecteurs multipolaires à ressorts reliès fixes à des sous-ensembles électriques, le fond des réglettes de centrage présentant des ouvertures pour le passage des broches de contact, caractérisé en ce que la plaque à circuits imprimés formant panneau arrière (1) porte une plage de broches sur toute son étendue et que les réglettes de centrage (3) présentent des encoches latérales (4) dans leurs parois longitudinales pour la réception de broches de contact (2) voisines.